# EUROPEAN PATENT APPLICATION

(11) **EP 4 415 213 A2**
(43) Date of publication of application: **14.08.2024**
(21) Application number: 24156408.7
(22) Date of filing: 07.02.2024
(51) Int. Cl.: H02J 7/00

(54) **SYSTEM AND METHOD FOR CONTROLLING AN AIRCRAFT BATTERY ASSEMBLY**

(30) Priority: 07.02.2023 US 202363443883 P
(71) Applicant: PRATT & WHITNEY CANADA CORP., Longueuil, Québec J4G 1A1 (CA)
(72) Inventor: FREER, Richard, (01BE5) Longueuil, J4G 1A1 (CA); SHENOUDA, Antwan, (01BE5) Longueuil, J4G 1A1 (CA); LAM, Simon, (01BE5) Longueuil, J4G 1A1 (CA); ROBACHE, Remi, (01BE5) Longueuil, J4G 1A1 (CA); GARIEPY, Raphael, (01BE5) Longueuil, J4G 1A1 (CA)
(74) Representative: Dehns

(57) **Abstract**

An assembly (24) for an aircraft (1000) includes an aircraft electrical distribution bus (66), a battery (70), and a battery monitoring system (72). The battery includes a plurality of battery strings (80). The plurality of battery strings is configured as a main subset (106) and a reserve subset (108). The battery monitoring system further includes a processor (100) in communication with a non-transitory memory (102) storing instructions, which instructions when executed by the processor, cause the processor to electrically connect the reserve subset to the aircraft electrical distribution bus by: determining the bus voltage and the battery string voltage of each battery string of the reserve subset, identifying a threshold voltage range of the reserve subset for electrically connecting the reserve subset to the aircraft electrical distribution bus, where identifying the threshold voltage range is based at least on the bus voltage, and electrically connecting at least one battery string of the reserve subset to the aircraft electrical distribution bus with the bus voltage within the identified threshold voltage range.

## Description

### TECHNICAL FIELD

This invention relates generally to aircraft batteries and, more particularly, to systems and methods for controlling an aircraft battery including a main battery strings and reserve battery strings electrically connected in parallel.

### BACKGROUND OF THE ART

Aircraft may include one or more batteries for supplying electrical power for an electrical distribution system of the aircraft and/or its propulsion system(s). The electrical connection of the battery to the electrical distribution system may, under some conditions, be controlled supplement the electrical power of the battery which is available to supply to the electrical distribution system. Various systems and methods for controlling aircraft batteries are known in the art. While these known systems and methods have various advantages, there is still room in the art for improvement.

### SUMMARY

It should be understood that any or all of the features or embodiments described herein can be used or combined in any combination with each and every other feature or embodiment described herein unless expressly noted otherwise.

According to an aspect of the present invention, an assembly for an aircraft includes an aircraft electrical distribution bus, a battery, and a battery monitoring system. The battery includes a plurality of battery strings. Each battery string is configured to be selectively electrically connected to the aircraft electrical distribution bus to direct electrical power to the aircraft electrical distribution bus. The plurality of battery strings is configured as a main subset of the plurality of battery strings and a reserve subset of the plurality of battery strings. Each of the main subset and the reserve subset include at least one battery string of the plurality of battery strings. The battery monitoring system includes a plurality of sensors. The plurality of sensors are configured to measure a bus voltage of the aircraft electrical distribution bus and a battery string voltage of each battery string. The battery monitoring system further includes a processor in communication with a non-transitory memory storing instructions, which instructions when executed by the processor, cause the processor to electrically connect the reserve subset of the plurality of battery strings to the aircraft electrical distribution bus by: determining the bus voltage and the battery string voltage of each battery string of the reserve subset of the plurality of battery strings with the plurality of sensors with at least one battery string of the main subset of the plurality of battery strings electrically connected to the aircraft electrical distribution bus, identifying a threshold voltage range of the reserve subset of the plurality of battery strings for electrically connecting the reserve subset of the plurality of battery strings to the aircraft electrical distribution bus, where identifying the threshold voltage range is based at least on the bus voltage, and electrically connecting at least one battery string of the reserve subset of the plurality of battery strings to the aircraft electrical distribution bus with the bus voltage within the identified threshold voltage range.

In any of the aspects or embodiments described above and herein, the plurality of battery strings may be configured to be selectively electrically connected in parallel.

In any of the aspects or embodiments described above and herein, each battery string of the plurality of battery strings may include a plurality of battery modules electrically connected in series.

In any of the aspects or embodiments described above and herein, each battery string may include a string contactor. The string contactor may be positionable in a closed string position or an open string position. The string contactor in the closed string position may be configured to direct electrical power from the respective battery string to the aircraft electrical distribution bus. The string contactor in the open string position may be configured to electrically isolate the respective battery string from the aircraft electrical distribution bus.

In any of the aspects or embodiments described above and herein, the at least one battery module of each battery string of the main subset of the plurality of battery strings may have a first battery chemistry configuration. The at least one battery module of each battery string of the reserve subset of the plurality of battery strings may have a second battery chemistry configuration. The first battery chemistry configuration may be different than the second battery chemistry configuration.

In any of the aspects or embodiments described above and herein, the at least one battery module of each battery string of the main subset of the plurality of battery strings may be rechargeable. The at least one battery module of each battery string of the reserve subset of the plurality of battery strings may be non-rechargeable.

In any of the aspects or embodiments described above and herein, the instructions when executed by the processor, may further cause the processor to electrically connect the reserve subset of the plurality of battery strings to the aircraft electrical distribution bus by electrically connecting the at least one battery string of the reserve subset of the plurality of battery strings to the aircraft electrical distribution bus with the battery string voltage of the at least one battery string of the reserve subset of the plurality of battery strings greater than the battery string voltage of the at least one battery string of the main subset of the plurality of battery strings.

In any of the aspects or embodiments described above and herein, the reserve subset of the plurality of battery strings may include at least a first reserve battery string and a second reserve battery string. The instructions when executed by the processor, may further cause the processor to electrically connect the reserve subset of the plurality of battery strings to the aircraft electrical distribution bus by determining the respective voltage range of the first reserve battery string and the second reserve battery string.

In any of the aspects or embodiments described above and herein, the instructions when executed by the processor, may further cause the processor to electrically connect the reserve subset of the plurality of battery strings to the aircraft electrical distribution bus by electrically connecting the at least one battery string of the reserve subset of the plurality of battery strings, including the first reserve battery string, to the aircraft electrical distribution bus while maintaining the second reserve battery string electrically disconnected from the aircraft electrical distribution bus.

In any of the aspects or embodiments described above and herein, the assembly may further include an aircraft propulsion system including a rotational assembly. The rotational assembly may include a propeller, a rotatable shaft and an electric motor. The electrical motor may be electrically connected to the aircraft electrical distribution bus. The electric motor may be configured to selectively drive the rotatable shaft and the propeller.

In any of the aspects or embodiments described above and herein, the plurality of sensors may be further configured to measure a temperature of the at least one battery module of each battery string. Identifying the threshold voltage range of the reserve subset of the plurality of battery strings for electrically connecting the reserve subset of the plurality of battery strings to the aircraft electrical distribution bus may be further based on the measured temperature.

According to another aspect of the present invention, a method for operating a battery assembly for an aircraft is provided. The method includes supplying electrical power to an aircraft electrical distribution bus with a battery. The battery includes a plurality of battery strings. Each battery string includes at least one battery module. The plurality of battery strings are configured as a main subset of the plurality of battery strings and a reserve subset of the plurality of battery strings. Each of the main subset of the plurality of battery strings and the reserve subset of the plurality of battery strings include at least one battery string of the plurality of battery strings. The main subset of the plurality of battery strings is electrically connected to the aircraft electrical distribution bus. The reserve subset of the plurality of battery strings is electrically disconnected from the aircraft electrical distribution bus. The method further includes electrically connecting the reserve subset of the plurality of battery strings to the aircraft electrical distribution bus by determining a bus voltage of the aircraft electrical distribution bus and a battery string voltage of each battery string of the reserve subset of the plurality of battery strings, identifying a threshold voltage range between the aircraft electrical distribution bus and the reserve subset of the plurality of battery strings for electrically connecting the reserve subset of the plurality of battery strings to the aircraft electrical distribution bus, and electrically connecting at least one battery string of the reserve subset of the plurality of battery strings to the aircraft electrical distribution bus with a voltage range between the bus voltage and the at least one battery string of the reserve subset of the plurality of battery strings within the identified threshold voltage range.

In any of the aspects or embodiments described above and herein, the plurality of battery strings may be configured to be selectively electrically connected in parallel.

In any of the aspects or embodiments described above and herein, the threshold voltage range may be a predetermined value.

In any of the aspects or embodiments described above and herein, the threshold voltage range may be dynamically determined based on at least the bus voltage.

According to another aspect of the present invention, an assembly for an aircraft includes an aircraft electrical distribution bus, an aircraft propulsion system, a battery, and a battery monitoring system. The aircraft propulsion system includes a rotational assembly. The rotational assembly includes a rotatable shaft and an electric motor. The electric motor is electrically connected to the aircraft electrical distribution bus. The electric motor is configured to selectively drive the rotatable shaft. The battery includes a plurality of battery strings configured to be selectively electrically connected in parallel. Each battery string is configured to be selectively electrically connected to the aircraft electrical distribution bus to direct electrical power to the aircraft electrical distribution bus. The plurality of battery strings is configured as a main subset of the plurality of battery strings and a reserve subset of the plurality of battery strings. The battery monitoring system includes a plurality of sensors. The plurality of sensors are configured to measure a bus voltage of the aircraft electrical distribution bus and a battery string voltage of each battery string. The battery monitoring system further includes a processor in communication with a non-transitory memory storing instructions, which instructions when executed by the processor, cause the processor to electrically connect the reserve subset of the plurality of battery strings to the aircraft electrical distribution bus by determining the bus voltage and the battery string voltage of each battery string of the reserve subset of the plurality of battery strings with the plurality of sensors with at least one battery string of the main subset of the plurality of battery strings electrically connected to the aircraft electrical distribution bus, identifying a threshold voltage range of the reserve subset of the plurality of battery strings for electrically connecting the reserve subset of the plurality of battery strings to the aircraft electrical distribution bus, where identifying the threshold voltage range is based at least on the bus voltage, and electrically connecting at least one battery string of the reserve subset of the plurality of battery strings to the aircraft electrical distribution bus with the bus voltage within the identified threshold voltage range.

In any of the aspects or embodiments described above and herein, the rotational assembly may further include a propeller. The electric motor may be configured to selectively drive the propeller via the rotatable shaft.

In any of the aspects or embodiments described above and herein, each battery string of the plurality of battery strings may include a plurality of battery modules electrically connected in series.

In any of the aspects or embodiments described above and herein, the plurality of battery modules of each battery string of the main subset of the plurality of battery strings may have a first battery chemistry configuration, the plurality of battery modules of each battery string of the reserve subset of the plurality of battery strings may have a second battery chemistry configuration, and the first battery chemistry configuration may be different than the second battery chemistry configuration.

In any of the aspects or embodiments described above and herein, the plurality of battery modules of each battery string of the main subset of the plurality of battery strings may be rechargeable and the plurality of battery modules of each battery string of the reserve subset of the plurality of battery strings may be non-rechargeable.

The present invention, and all its aspects, embodiments and advantages associated therewith will become more readily apparent in view of the detailed description provided below, including the accompanying drawings.

### DESCRIPTION OF THE DRAWINGS

FIG. 1 illustrates a perspective view of a portion of an aircraft including a propulsion system, in accordance with one or more embodiments of the present invention.
FIG. 2 schematically illustrates a side view of an aircraft propulsion system including a gas turbine engine, in accordance with one or more embodiments of the present invention.
FIG. 3 schematically illustrates portion of a battery assembly including a battery string, in accordance with one or more embodiments of the present v.
FIG. 4 schematically illustrates another portion of a battery assembly including a plurality of battery strings electrically connected in parallel, in accordance with one or more embodiments of the present invention.
FIG. 5 illustrates a block diagram depicting a method for operating a battery assembly for an aircraft, in accordance with one or more embodiments of the present invention.
FIG. 6A-C illustrate graphs of battery string voltages for a main subset and a reserve subset of a battery, in accordance with one or more embodiments of the present invention.

### DETAILED DESCRIPTION

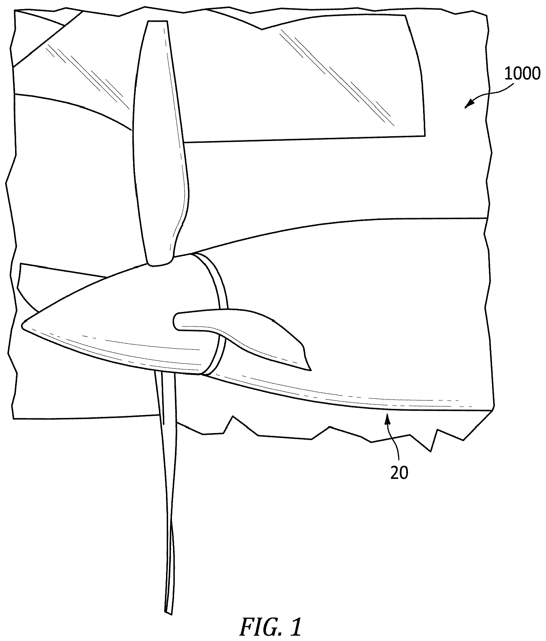

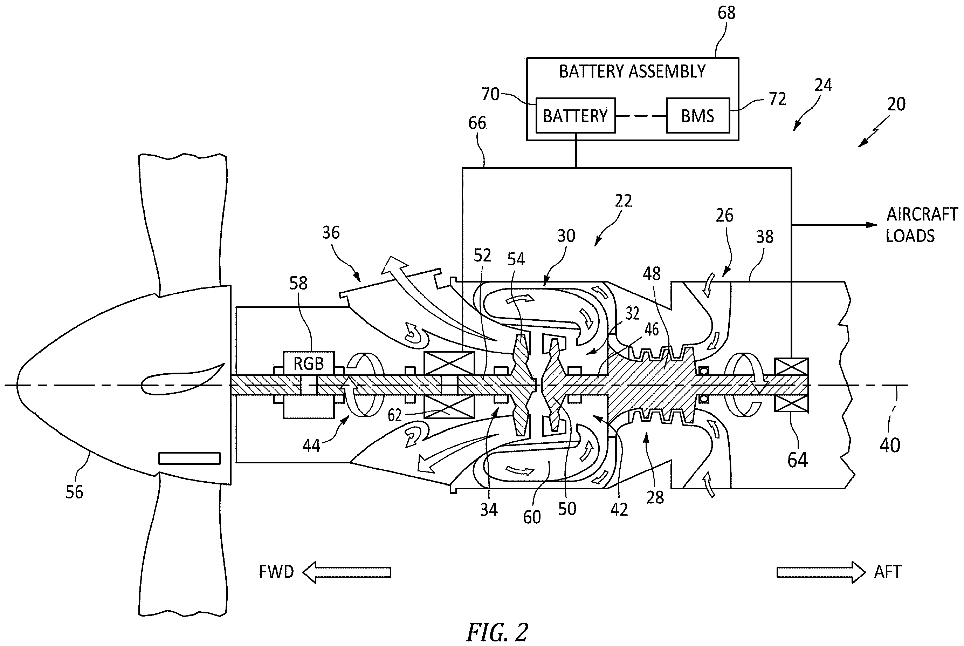

FIGS. 1 and 2 illustrate a propulsion system 20 configured for an aircraft, such as the aircraft 1000 of FIG. 1. Briefly, the aircraft may be a fixed-wing aircraft (e.g., an airplane), a rotary-wing aircraft (e.g., a helicopter), a tilt-rotor aircraft, a tilt-wing aircraft, or any other aerial vehicle. Moreover, the aircraft may be a manned aerial vehicle or an unmanned aerial vehicle (UAV, e.g., a drone). The aircraft propulsion system 20 of FIG. 2 includes a gas turbine engine 22. However, the present invention is also applicable to propulsion systems which do not include gas turbine engines such as, but not limited to, a battery-electric propulsion system (e.g., an electric-motor driven propeller system). The propulsion system 20 additionally includes or is otherwise electrically connected to an electrical distribution system 24.

FIG. 2 illustrates a side, cutaway view of the propulsion system 20 illustrating the gas turbine engine 22 and the electrical distribution system 24. The gas turbine engine 22 of FIG. 2 is configured as a hybrid-electric, multi-spool turboprop gas turbine engine. However, it should be understood that aspects of the present invention may be equally applicable to other configurations of gas turbine engines such as, but not limited to, a turboshaft gas turbine engine, a turboprop gas turbine engine, a turbojet gas turbine engine, a propfan gas turbine engine, an open rotor gas turbine engine, an auxiliary power unit (APU), or the like.

The gas turbine engine 22 of FIG. 2 includes an air inlet 26, a compressor 28, a combustor 30, a high-pressure turbine 32, a power turbine 34, an exhaust 36, and an engine static structure 38. The air inlet 26, the compressor 28, the combustor 30, the high-pressure turbine 32, the power turbine 34, and the exhaust 36 are arranged sequentially along an axial centerline 40 (e.g., a rotational axis) of the gas turbine engine 22. The engine static structure 38 may include, for example, one or more engine cases for the gas turbine engine 22. The engine static structure 38 may additionally include cowlings, bearing assemblies, and/or other structural components of the gas turbine engine 22. The one or more engine cases form, house, and/or structurally support one or more of the air inlet 26, the compressor 28, the combustor 30, the high-pressure turbine 32, the power turbine 34, and the exhaust 36.

Components of the gas turbine engine 22 of FIG. 2, such as components of the compressor 28, the high-pressure turbine 32, and the power turbine 34, are arranged as a first rotational assembly 42 (e.g., a high-pressure spool) and a second rotational assembly 44 (e.g., a power spool). The first rotational assembly 42 and the second rotational assembly 44 are mounted for rotation about the axial centerline 40 relative to the engine static structure 38. The gas turbine engine 22 of FIG. 2 has a "free turbine" configuration in which power for aircraft propulsion is extracted by the second rotational assembly 44 downstream of (e.g., from the exhaust of) the first rotational assembly 42. The present invention, however, is not limited to free turbine gas turbine engine configurations.

The first rotational assembly 42 includes a first shaft 46, a bladed compressor rotor 48 for the compressor 28, and a bladed turbine rotor 50 for the high-pressure turbine 32. The first shaft 46 interconnects the bladed compressor rotor 48 and the bladed turbine rotor 50. The second rotational assembly 44 includes a second shaft 52, a bladed power turbine rotor 54 for the power turbine 34, and a propeller 56. The second shaft 52 is connected to the bladed power turbine rotor 54. The second shaft 52 may be directly or indirectly connected to the propeller 56. For example, the second shaft 52 may be configured to rotatably drive the propeller 56 via a reduction gear box (RGB) 58. The second rotation assembly 44 may include additional components (e.g., a propeller input shaft) for interconnecting the second shaft 52 with the bladed power turbine rotor 54 and the propeller 56. The RGB 58 may be configured to drive the propeller 56 at a reduced rotational speed relative to the second shaft 52. Alternatively, the second shaft 52 may directly interconnect the bladed power turbine rotor 54 and the propeller 56.

During operation of the gas turbine engine 22 of FIG. 2, ambient air enters the gas turbine engine 22 through the air inlet 26 and is directed into the compressor 28. The ambient air is compressed by the bladed compressor rotor 48 and directed into a combustion chamber 60 of the combustor 30. Fuel is injected into the combustion chamber 60 and mixed with the compressed air to provide a fuel-air mixture. This fuel-air mixture is ignited, and combustion products thereof flow through and sequentially cause the bladed turbine rotor 50 and the bladed power turbine rotor 54 to rotate. The rotation of the bladed turbine rotor 50 and the bladed power turbine rotor 54 respectively drive rotation of the first rotational assembly 42 and the second rotational assembly 44. Rotation of the second rotational assembly 44 further drives rotation of the propeller 56 to provide propulsion (e.g., thrust) for the propulsion system 20 and the aircraft 1000 (see FIG. 1). Combustion exhaust gas flowing past the bladed power turbine rotor 54 along is directed out of the gas turbine engine 22 through the exhaust 36.

The electrical distribution system 24 of FIG. 2 is configured to supply electrical power for electrical loads of the propulsion system 20 and/or the aircraft 1000 (see FIG. 1). Examples of electrical loads for the aircraft 1000 include, but are not limited to, electronic control systems, environmental control systems, electric motors, lighting systems, communication systems, AC/DC conversion systems, and the like. The electrical distribution system 24 of FIG. 2 includes an electric motor 62, a generator 64, an electrical distribution bus 66, and a battery assembly 68. The present invention, however, is not limited to the particular configuration of the electrical distribution system 24 of FIG. 2. The electrical distribution bus 66 is a direct current (DC) electrical distribution bus. The electrical distribution system 24 may include one or more additional electrical distribution buses (e.g., alternating current (AC) electrical distribution buses) which may be configured to receive and/or supply electrical current to the electrical distribution bus 66 using one or more AC/DC conversion systems.

The electric motor 62 is configured to apply a rotational force to second rotational assembly 44. For example, the electric motor 62 may be directly or indirectly coupled to the second shaft 52 to drive the second shaft 52 by applying a rotational force to the second shaft 52. The electric motor 62 may further include a clutch configured to selectively couple the electric motor 62 to the second shaft 52 or to an intermediate component of the second rotational assembly 44. Accordingly, the electric motor 62 may be configured to apply a rotational force to the second rotational assembly 44 to facilitate rotation of the propeller 56 by the second rotational assembly 44. For example, the electric motor 62 in combination with the bladed power turbine rotor 54 may provide the rotational force for driving the propeller 56. The electric motor 62 may be selected to be sufficiently powerful to drive the propeller 56 during all flight conditions independent of the bladed power turbine rotor 54. Accordingly, the electric motor 62 may provide all of the rotational force for driving the propeller 56. The electric motor 62 is electrically connected to the electrical distribution bus 66 and configured to receive electrical power from the electrical distribution bus 66 for operation of the electric motor 62.

The generator 64 is configured to supply electrical power to the electrical distribution system 24. The generator 64 of FIG. 2 is operably coupled to the first shaft 46. For example, the generator 64 may be operably coupled to the first shaft 46 by an accessory gear box (not shown) or other speed-reducing gear assembly. The first shaft 46 drives rotation of the generator 64 to generate electrical power for the electrical distribution system 24. The generator 64 is connected in electrical communication with the electrical distribution bus 66 to supply electrical power to the electrical distribution bus 66 for electrical loads of the propulsion system 20 and/or the aircraft 1000 (see FIG. 1). The present invention is not limited to the particular generator 64 configuration of FIG. 2. For example, the generator 64 may alternatively be operably coupled to and driven by the second shaft 52. Moreover, electrical power for the electrical distribution system 24 may additionally or alternatively be provided by other electrical power sources which are independent of the propulsion system 20 such as, but not limited to, a generator of another propulsion system (e.g., for multi-propulsion-system aircraft), an auxiliary power unit (APU), a fuel cell (e.g., hydrogen fuel cell) assembly, or another power source disposed on the aircraft 1000 or otherwise outside of the propulsion system 20, and/or a ground-based power supply (e.g., an airport electrical distribution system, generator, or other electrical power supply or battery charging device) external to the aircraft 1000.

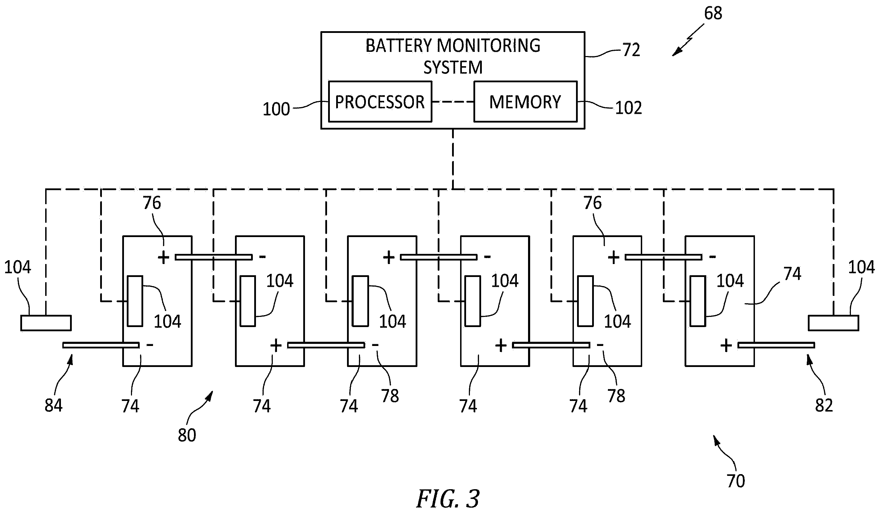

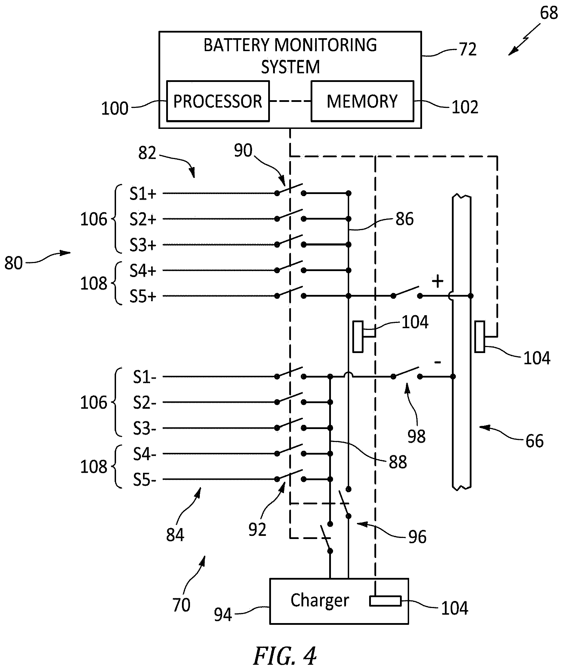

Referring to FIGS. 3 and 4, the battery assembly 68 includes a battery 70 and a battery monitoring system (BMS) 72. The battery 70 is configured to selectively supply electrical power to the electrical distribution bus 66 independently (e.g., as a single power source for the electrical distribution bus 66) or in combination with the generator 64 and/or other power sources. The battery 70 may be disposed, for example, in the aircraft 1000 and/or its propulsion systems 20. The battery 70 of FIG. 3 includes a plurality of battery modules 74 (e.g., battery packs). Each battery module 74 may include a plurality of discrete battery cells electrically connected together (e.g., using series and/or parallel electrical connections) to form the battery module 74. The present invention, however, is not limited to this particular configuration of the battery modules 74. The battery modules 74 (e.g., and their battery cells) have a battery chemistry configuration which includes materials forming the anode, cathode, and/or electrolyte of the battery modules 74. For example, the battery chemistry configurations for the battery modules 74 may include, but are not limited to, lead acid, nickel cadmium (NiCd), nickel-metal hydride (Ni-MH), lithium-ion (Li-ion), lithium-polymer (Li-poly), lithium metal, alkaline, carbon zinc, and the like. The battery modules 74 may be rechargeable or non-rechargeable. The battery modules 74 may be rechargeable, for example, where they are configured to be discharged and subsequently recharged by receiving an electrical current (e.g., from an electrical power source). In other words, rechargeable battery modules 74 have a battery chemistry configuration for which the associated electrochemical reaction is reversible. The battery modules 74 may be non-rechargeable, for example, where they cannot be meaningfully, subsequently recharged following discharge. In other words, non-rechargeable battery modules 74 have a battery chemistry configuration for which the associated electrochemical reaction is not reversible. These non-rechargeable battery modules 74 may be installed in the battery assembly 68 in a fully-charged or nearly fully charged condition. The non-rechargeable battery modules 74 may be discarded and replaced as the non-rechargeable battery modules 74 are discharged below suitable charge parameters.

FIG. 3 schematically illustrates a group of the battery modules 74 electrically connected in series to form a battery string 80 of the battery 70. For example, each battery module 74 of the battery string 80 of FIG. 3 is electrically connected in series (e.g., positive to negative or negative to positive) to one or more other battery modules 74 of the battery string 80 of FIG. 3. The battery string 80 includes a positive string terminal 82 and a negative string terminal 84 for connecting the battery string 80 in electrical communication with other portions of the battery 70. The battery string 80 of FIG. 3 includes six (6) battery modules 74 electrically connected in series. The present invention, however, is not limited to any particular number of battery modules 74 for the battery string 80. Moreover, the battery modules 74 of the battery string 80 may be electrically connected together using series and/or parallel electrical connections as necessary to configure the battery string 80 with the desired electrical characteristics (e.g., voltage output, power output, etc.) for the battery string 80.

FIG. 4 schematically illustrates a portion of the battery assembly 68 in which the battery 70 includes a plurality of the battery strings 80. The plurality of battery strings 80 of FIG. 4 includes five (5) battery strings S1-5 electrically connected together in parallel. For example, the positive string terminals 82 (e.g., S1+, S2+, S3+, S4+, S5+) of the battery strings 80 of FIG. 4 are electrically connected together at a positive battery terminal 86 and the negative string terminals 84 (e.g., S1-, S2-, S3-, S4-, S5-) are electrically connected together at a negative battery terminal 88.

Each battery string 80 of FIG. 4 includes a positive string contactor 90 and a negative string contactor 92. The positive string contactor 90 for each battery string 80 is disposed at (e.g., on, adjacent, or proximate) the respective positive string terminal 82 or otherwise electrically between the respective positive string terminal 82 and the positive battery terminal 86. The positive string contactor 90 is selectively positionable in a closed position or an open position. In the closed position, the positive string contactor 90 is configured to convey electrical current between the positive battery terminal 86 and the respective positive string terminal 82. In the open position, the positive string contactor 90 is configured to interrupt (e.g., obstruct, prevent, etc.) electrical current between the positive battery terminal 86 and the respective positive string terminal 82. The negative string contactor 92 for each battery string 80 is disposed at (e.g., on, adjacent, or proximate) the respective negative string terminal 84 or otherwise electrically between the respective negative string terminal 84 and the negative battery terminal 88. The negative string contactor 92 is selectively positionable in a closed position or an open position. In the closed position, the negative string contactor 92 is configured to convey electrical current between the negative battery terminal 88 and the respective negative string terminal 84. In the open position, the negative string contactor 92 is configured to interrupt (e.g., obstruct, prevent, etc.) electrical current between the negative battery terminal 88 and the respective negative string terminal 84. Accordingly, the positive string contactor 90 and the negative string contactor 92 may be controlled to selectively electrically connect or selectively electrically disconnect the respective battery string 80 from the battery terminals 86, 88 and/or the electrical distribution bus 66. The positive string contactor 90 and the negative string contactor 92 may be configured as electrically-controlled relays or switches which may be controlled by an electrical control signal to position the respective positive string contactor 90 and negative string contactor 92 in the closed position or the open position. While each battery string 80 of FIG. 4 includes both the positive string contactor 90 and the negative string contactor 92, the present invention is not limited to the use of both the positive string contactor 90 and the negative string contactor 92 for the battery string 80 (e.g., the battery string 80 may include the positive string contactor 90 or the negative string contactor 92). Of course, the battery 70 may alternatively include other selective electrical power interruption devices such as, but not limited to electrical circuit breakers or electrical switches.

The plurality of battery strings 80 may be configured as a main subset 106 of the plurality of battery strings 80 (e.g., a main battery) and a reserve subset 108 of the plurality of battery strings 80 (e.g., a reserve battery). Each of the main subset 106 and the reserve subset 108 may include at least one battery string 80 of the plurality of battery strings 80. For example, the main subset 106 of FIG. 4 includes the battery strings S1-3 and the reserve subset 108 of FIG. 4 includes the battery strings S4-5. The present invention, however, is not limited to any particular number or relative proportion of the battery strings 80 for the main subset 106 and the reserve subset 108. The main subset 106 may generally be electrically connected to the electrical distribution bus 66 (e.g., during a flight condition for the aircraft 1000) to provide electrical power for electrical loads of the propulsion system 20 and/or the aircraft 1000 (see FIGS. 1 and 2). In contrast, the reserve subset 108 may generally be electrically disconnected from the electrical distribution bus 66. For example, the reserve subset 108 may be electrically connected to the electrical distribution bus 66 during emergency conditions of the aircraft 1000 or its propulsion system 20 and/or when the battery strings 80 of the main subset 106 have been discharged below a minimum charge level (e.g., a predetermined minimum charge level). The main subset 106 (e.g., the battery modules 74 of the main subset 106) and the reserve subset 108 (e.g., the battery modules 74 of the reserve subset 108) may have a same or different string configuration. The battery modules 74 of the main subset 106 may have a different energy capacity, a different energy density, a battery chemistry configuration, a different electrical current limit, a different temperature limit, or one or more other configurational differences relative to the battery modules 74 of the reserve subset 108. For example, the battery modules 74 of the main subset 106 may have a battery chemistry configuration such that the battery modules 74 of the main subset 106 are rechargeable. The battery modules 74 of the reserve subset 108 may have a battery chemistry configuration such that the battery modules 74 of the reserve subset 108 are non-rechargeable but have a greater energy density than the battery modules 74 of the main subset 106. Alternatively, the battery modules 74 of the reserve subset 108 may have a battery chemistry configuration such that the battery modules 74 of the reserve subset 108 are rechargeable, but only capable of being recharged a relatively small number of times (e.g., a low recharge cycle limit) relative to the battery modules 74 of the main subset 106.

The battery 70 of FIG. 4 further includes a charger 94, main charger contactors 96, and main battery contactors 98. The charger 94 is an electrical power source configured to supply electrical power to the battery terminals 86, 88 for charging one or more of the battery strings 80 (e.g., the battery strings S1, S2, S3, S4, and/or S5 of FIG. 4). The charger 94 may be formed by or may otherwise include one or more electrical power sources such as, but not limited to, the generator 64, a generator of another propulsion system (e.g., for multi-propulsion-system aircraft), an auxiliary power unit (APU), a fuel cell (e.g., hydrogen fuel cell) assembly, or another power source disposed on the aircraft 1000 or otherwise outside of the propulsion system 20, and/or a ground-based power supply (e.g., an airport electrical distribution system, generator, or other electrical power supply or battery charging device) external to the aircraft 1000. The main charger contactors 96 are configured to selectively connect the charger 94 in electrical communication with the battery 70 (e.g., with the positive battery terminal 86 and the negative battery terminal 88). The main battery contactors 98 are configured to selectively connect the electrical distribution bus 66 in electrical communication with the battery 70 (e.g., with the positive battery terminal 86 and the negative battery terminal 88). Each of the main charger contactors 96 and the main battery contactors 98 is selectively positionable in a closed position or an open position. In the closed position, each of the main charger contactors 96 and the main battery contactors 98 is configured to convey electrical current. In the open position, each of the main charger contactors 96 and the main battery contactors 98 is configured to interrupt (e.g., obstruct, prevent, etc.) electrical current. The main charger contactors 96 and the main battery contactors 98 may be configured as electrically-controlled relays or switches which may be controlled by an electrical control signal to position the main charger contactors 96 and the main battery contactors 98 in their respective closed position or open position.

The battery monitoring system 72 of FIGS. 2-4 includes a processor 100 and memory 102. The memory 102 is in signal communication with the processor 100. The processor 100 may include any type of computing device, computational circuit, or any type of process or processing circuit capable of executing a series of instructions that are stored in the memory 102, thereby causing the processor 100 to perform or control one or more steps or other processes. The processor 100 may include multiple processors and/or multicore CPUs and may include any type of processor, such as a microprocessor, digital signal processor, co-processors, a microcontroller, a microcomputer, a central processing unit, a field programmable gate array, a programmable logic device, a state machine, logic circuitry, analog circuitry, digital circuitry, etc., and any combination thereof. The instructions stored in memory 102 may represent one or more algorithms for controlling and/or monitoring aspects of the battery assembly 68, and the stored instructions are not limited to any particular form (e.g., program files, system data, buffers, drivers, utilities, system programs, etc.) provided they can be executed by the processor 100. The memory 102 may be a non-transitory computer readable storage medium configured to store instructions that when executed by one or more processors, cause the one or more processors to perform or cause the performance of certain functions. The memory 102 may be a single memory device or a plurality of memory devices. A memory device may include a storage area network, network attached storage, as well a disk drive, a read-only memory, random access memory, volatile memory, non-volatile memory, static memory, dynamic memory, flash memory, cache memory, and/or any device that stores digital information. One skilled in the art will appreciate, based on a review of this disclosure, that the implementation of the battery monitoring system 72 may be achieved via the use of hardware, software, firmware, or any combination thereof. The battery monitoring system 72 may also include input and output devices (e.g., keyboards, buttons, switches, touch screens, video monitors, sensor readouts, data ports, etc.) that enable the operator to input instructions, receive data, etc.

The battery monitoring system 72 includes a plurality of sensors 104 to monitor operational parameters of the battery 70 including, but not limited to, voltage, current, and temperature. For example, the battery monitoring system 72 may include one or more of the sensors 104 at (e.g., on, adjacent, or proximate) each battery module 74 to monitor the health of each battery module 74 and or to monitor operational parameters of each battery module 74 such as, but not limited to, voltage, current, and temperature. The battery monitoring system 72 may additionally include one or more sensors 104 for monitoring voltage and current parameters for each battery string 80, for the battery 70 (e.g., at the battery terminals 86, 88), and/or for the charger 94.

The battery monitoring system 72 may be connected in electrical and/or electronic communication with the string contactors 90, 92. The battery monitoring system 72 may control the string contactors 90, 92 for positioning in their respective open positions or closed positions using a control signal (e.g., a control current, electronic signal, etc.). Similarly, the battery monitoring system 72 may be connected in electrical and/or electronic communication with the main charger contactors 96 and/or the main battery contactors 98 to control the main charger contactors 96 and/or the main battery contactors 98 in their respective open positions or closed positions. Alternatively, the main battery contactors 98 may be controlled independent of the battery monitoring system 72, for example, manually (e.g., by a pilot or other operator) or by another control system of the propulsion system 20 or the aircraft (see FIG. 1).

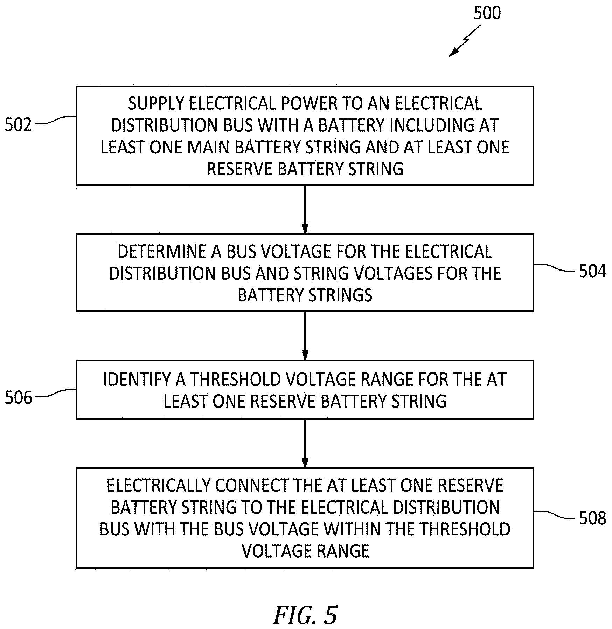

Referring to FIGS. 4-6, a Method 500 for operating a battery assembly including a battery having a plurality of battery strings (e.g., a plurality of battery strings electrically connected in parallel) is provided. FIG. 5 illustrates a flowchart for the Method 500. The Method 500 may be performed for the battery assembly 68, as described herein. The battery monitoring system 72 may be used to execute or control one or more steps of the Method 500 for the battery 70. For example, the processor 100 may execute instructions stored in memory 102, thereby causing the battery monitoring system 72 and/or its processor 100 to execute or otherwise control one or more steps of the Method 500. However, it should be understood that the Method 500 is not limited to use with the battery assembly 68 described herein. Unless otherwise noted herein, it should be understood that the steps of Method 500 are not required to be performed in the specific sequence in which they are discussed below and, in some embodiments, the steps of Method 500 may be performed separately or simultaneously.

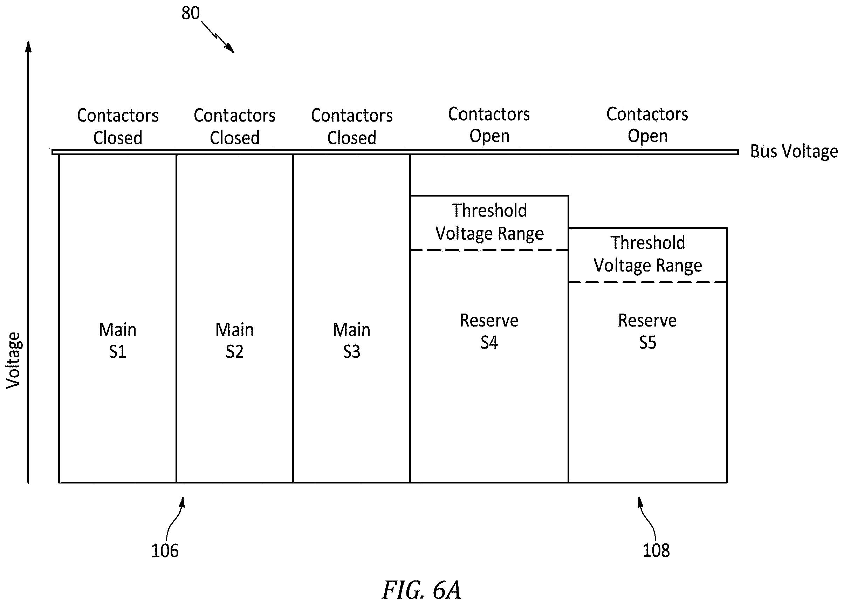

Step 502 includes supplying electrical power to the electrical distribution bus 66 with the battery 70. For example, as shown in FIG. 6A, one or more battery strings 80 of the main subset 106 may be electrically connected to the electrical distribution bus 66 with the main battery contactors 98 and the respective string contactors 90, 92 for the one or more battery strings 80 of the main subset 106 in the closed position. The battery strings 80 of the reserve subset 108 may be electrically disconnected from the electrical distribution bus 66. For example, the reserve subset 108 may be electrically disconnected from the electrical distribution bus 66 unless the reserve subset 108 is to be used for an emergency condition of the aircraft 1000 or its propulsion system 20 and/or when the battery strings 80 of the main subset 106 have been discharged below a minimum charge level. The battery strings 80 of the reserve subset 108 may be maintained at a lower battery string voltage, relative to the battery strings 80 of the main subset 106, to allow the battery strings 80 of the reserve subset 108 to be more easily electrically connected to the electrical distribution bus 66 as the battery strings 80 of the main subset 106 become increasingly discharged (e.g., as the electrical distribution bus 66 voltage decreases).

Step 504 includes determining a bus voltage of the electrical distribution bus 66 and/or battery string voltages of the battery strings 80 of the reserve subset 108. For example, the battery monitoring system 72 may determine the bus voltage of the electrical distribution bus 66 and the battery string voltage of each battery string 80 of the reserve subset 108 using the sensors 104. The battery strings 80 of the main subset 106 which are electrically connected to the electrical distribution bus 66 may have respective string voltages which are the same as or substantially the same as the bus voltage.

Step 506 includes identifying a threshold voltage range for the battery strings 80 of the reserve subset 108. For example, the battery monitoring system 72 may identify a threshold voltage range for each battery string 80 of the reserve subset 108. The threshold voltage range identifies a voltage range relative to the respective battery string of the reserve subset 108. With the bus voltage of the electrical distribution bus 66 within the threshold voltage range, the respective battery string 80 of the reserve subset 108 may be safely electrically connected to the electrical distribution bus 66. For example, the threshold voltage range identifies a voltage range within which a respective battery string 80 of the reserve subset 108 may be electrically connected to the electrical distribution bus 66 (e.g., by closing the respective string contactors 90, 92) so as to prevent or minimize the likelihood of damage to the respective battery string 80, the respective string contactors 90, 92, and/or other components of the battery assembly 68 which may be caused by high electrical current, high temperatures, electric arcs (e.g., arc discharge), or the like. All or a substantially portion of the identified threshold voltage range for a respective battery string 80 of the reserve subset 108 may be less than the battery string voltage for the respective battery string 80 (e.g., the battery string voltage may be a maximum point for the threshold voltage range). This is because upon electrically connecting the respective battery string 80 of the reserve subset 108 to the electrical distribution bus 66, the battery string voltage of the respective battery string 80 will be expected to decrease (e.g., because the battery string is experiencing electrical load) while the battery string voltages of the other battery strings 80 electrically connected to the electrical distribution bus 66 will be expected to increase (e.g., because the other battery strings 80 may experience a decrease in electrical load). Accordingly, the electrically-connected battery strings 80 of the main subset 106 and the reserve subset 108 may have substantially equalized battery string voltages as the battery strings 80 of the reserve subset 108 are electrically connected. The threshold voltage range may be a predetermined value (e.g., stored in memory 102). Alternatively, the threshold voltage range may be dynamically determined by the battery monitoring system 72 based on one or more factors such as, but not limited to, battery module 74 and/or battery string 80 energy capacity, battery module 74 chemistry configurations, battery module 74 temperatures, string contactor 90, 92 configurations and electrical current limits, and bus voltage of the electrical distribution bus 66. Routine experimentation may be performed by a person of ordinary skill in the art to determine a suitable threshold voltage range for electrically connecting battery strings 80 of the reserve subset 108 for a particular electrical distribution system 24 and battery assembly 68 in accordance with and as informed by one or more aspects of the present invention.

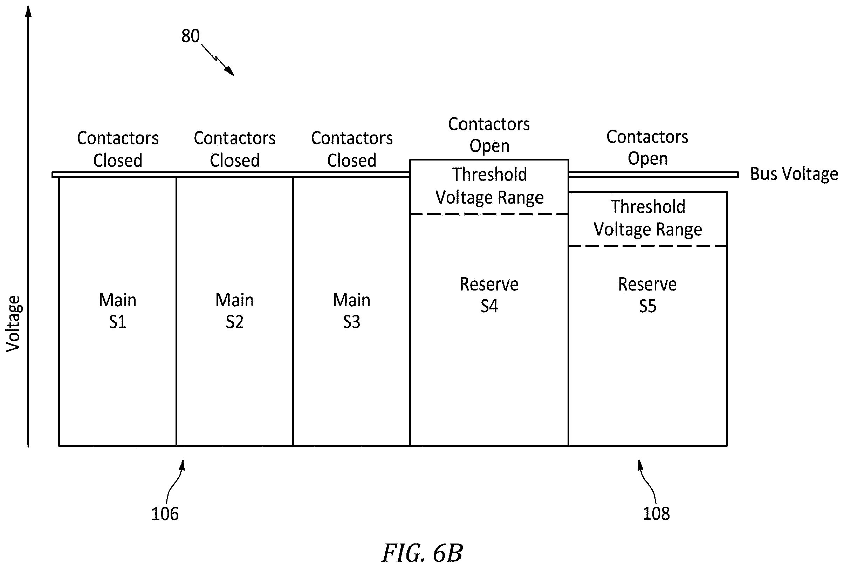

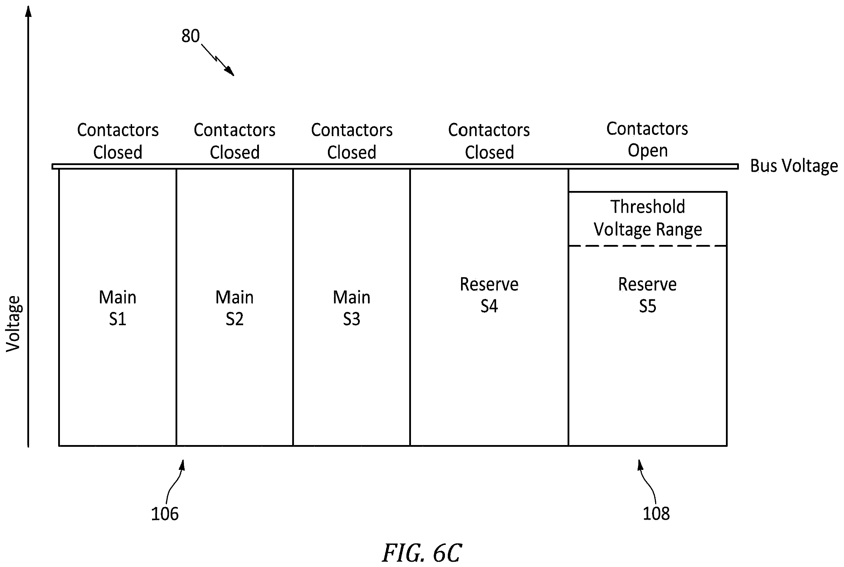

Step 508 includes electrically connecting one or more of the battery strings 80 of the reserve subset 108 to the electrical distribution bus 66. For example, each battery string 80 of the reserve subset 108 may be electrically connected to the electrical distribution bus 66 by the battery monitoring system 72 when the bus voltage for the electrical distribution bus 66 has decreased to within the threshold voltage range for each respective battery string 80 of the reserve subset 108 (see FIG. 6B). Because the battery strings 80 of the reserve subset 108 may each have different battery string voltages, the battery strings 80 of the reserve subset 108 may not be electrically connected to the electrical distribution bus 66 at the same time (see FIG. 6C). For example, the battery monitoring system 72 may electrically connect one or more battery strings 80 of the reserve subset 108 to the electrical distribution bus 66 while maintaining one or more other battery strings 80 of the reserve subset 108 electrically disconnected from the electrical distribution bus 66.

While the principles of the invention have been described above in connection with specific apparatuses and methods, it is to be clearly understood that this description is made only by way of example and not as limitation on the scope of the disclosure. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this disclosure by way of reference). It is noted that these connections are general and, unless specified otherwise, may be direct or indirect and that this specification is not intended to be limiting in this respect. Any reference to attached, fixed, connected, or the like may include permanent, removable, temporary, partial, full and/or any other possible attachment option.

As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the inventions may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the inventions--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements.

## Claims

1. An assembly (24) for an aircraft (1000), the assembly comprising:
an aircraft electrical distribution bus (66);
a battery (70) including a plurality of battery strings (80), each battery string including at least one battery module (74), each battery string configured to be selectively electrically connected to the aircraft electrical distribution bus to direct electrical power to the aircraft electrical distribution bus, the plurality of battery strings configured as a main subset (106) of the plurality of battery strings and a reserve subset (108) of the plurality of battery strings, each of the main subset of the plurality of battery strings and the reserve subset of the plurality of battery strings including at least one battery string of the plurality of battery strings; and
a battery monitoring system (72) including a plurality of sensors (104), the plurality of sensors configured to measure a bus voltage of the aircraft electrical distribution bus and a battery string voltage of each battery string, the battery monitoring system further including a processor (100) in communication with a non-transitory memory (102) storing instructions, which instructions when executed by the processor, cause the processor to electrically connect the reserve subset of the plurality of battery strings to the aircraft electrical distribution bus by:
determining the bus voltage and the battery string voltage of each battery string of the reserve subset of the plurality of battery strings with the plurality of sensors with at least one battery string of the main subset of the plurality of battery strings electrically connected to the aircraft electrical distribution bus;
identifying a threshold voltage range of the reserve subset of the plurality of battery strings for electrically connecting the reserve subset of the plurality of battery strings to the aircraft electrical distribution bus, identifying the threshold voltage range based at least on the bus voltage; and
electrically connecting at least one battery string of the reserve subset of the plurality of battery strings to the aircraft electrical distribution bus with the bus voltage within the identified threshold voltage range.

2. The assembly of claim 1, wherein the plurality of battery strings are configured to be selectively electrically connected in parallel.

3. The assembly of claim 1, wherein the at least one battery module includes a plurality of battery modules electrically connected in series.

4. The assembly of any preceding claim, wherein each battery string includes a string contactor, the string contactor positionable in a closed string position or an open string position, the string contactor in the closed string position configured to direct electrical power from the respective battery string to the aircraft electrical distribution bus, the string contactor in the open string position configured to electrically isolate the respective battery string from the aircraft electrical distribution bus.

5. The assembly of any preceding claim, wherein:
the at least one battery module of each battery string of the main subset of the plurality of battery strings have a first battery chemistry configuration;
the at least one battery module of each battery string of the reserve subset of the plurality of battery strings have a second battery chemistry configuration; and
the first battery chemistry configuration is different than the second battery chemistry configuration.

6. The assembly of claim 5, wherein:
the at least one battery module of each battery string of the main subset of the plurality of battery strings is rechargeable; and
the at least one battery module of each battery string of the reserve subset of the plurality of battery strings is non-rechargeable.

7. The assembly of any preceding claim, wherein the instructions when executed by the processor, further cause the processor to electrically connect the reserve subset of the plurality of battery strings to the aircraft electrical distribution bus by electrically connecting the at least one battery string of the reserve subset of the plurality of battery strings to the aircraft electrical distribution bus with the battery string voltage of the at least one battery string of the reserve subset of the plurality of battery strings greater than the battery string voltage of the at least one battery string of the main subset of the plurality of battery strings.

8. The assembly of any preceding claim, wherein:
the reserve subset of the plurality of battery strings includes at least a first reserve battery string and a second reserve battery string; and
the instructions when executed by the processor, further cause the processor to electrically connect the reserve subset of the plurality of battery strings to the aircraft electrical distribution bus by determining the respective voltage range of the first reserve battery string and the second reserve battery string, optionally, wherein:
the instructions when executed by the processor, further cause the processor to electrically connect the reserve subset of the plurality of battery strings to the aircraft electrical distribution bus by electrically connecting the at least one battery string of the reserve subset of the plurality of battery strings, including the first reserve battery string, to the aircraft electrical distribution bus while maintaining the second reserve battery string electrically disconnected from the aircraft electrical distribution bus.

9. The assembly of any preceding claim, further comprising an aircraft propulsion system including a rotational assembly, the rotational assembly including a propeller, a rotatable shaft and an electric motor, the electrical motor electrically connected to the aircraft electrical distribution bus, the electric motor configured to selectively drive the rotatable shaft and the propeller.

10. The assembly of any preceding claim, wherein:
the plurality of sensors are further configured to measure a temperature of the at least one battery module of each battery string; and
identifying the threshold voltage range of the reserve subset of the plurality of battery strings for electrically connecting the reserve subset of the plurality of battery strings to the aircraft electrical distribution bus is further based on the measured temperature.

11. A method for operating a battery assembly for an aircraft, the method comprising:
supplying electrical power to an aircraft electrical distribution bus with a battery, the battery including a plurality of battery strings, each battery string including at least one battery module, the plurality of battery strings configured as a main subset of the plurality of battery strings and a reserve subset of the plurality of battery strings, each of the main subset of the plurality of battery strings and the reserve subset of the plurality of battery strings including at least one battery string of the plurality of battery strings, the main subset of the plurality of battery strings electrically connected to the aircraft electrical distribution bus, the reserve subset of the plurality of battery strings electrically disconnected from the aircraft electrical distribution bus; and
electrically connecting the reserve subset of the plurality of battery strings to the aircraft electrical distribution bus by:
determining a bus voltage of the aircraft electrical distribution bus and a battery string voltage of each battery string of the reserve subset of the plurality of battery strings;
identifying a threshold voltage range of the reserve subset of the plurality of battery strings for electrically connecting the reserve subset of the plurality of battery strings to the aircraft electrical distribution bus; and
electrically connecting at least one battery string of the reserve subset of the plurality of battery strings to the aircraft electrical distribution bus with the bus voltage within the identified threshold voltage range.

12. The method of claim 11, wherein the plurality of battery strings are configured to be selectively electrically connected in parallel.

13. The method of claim 11 or 12, wherein the threshold voltage range is:
a predetermined value; or
dynamically determined based on at least the bus voltage.

14. An assembly for an aircraft, the assembly including:
an aircraft electrical distribution bus;
an aircraft propulsion system including a rotational assembly, the rotational assembly including a rotatable shaft and an electric motor, the electric motor electrically connected to the aircraft electrical distribution bus, the electric motor configured to selectively drive the rotatable shaft;
a battery including a plurality of battery strings configured to be selectively electrically connected in parallel, each battery string configured to be selectively electrically connected to the aircraft electrical distribution bus to direct electrical power to the aircraft electrical distribution bus, the plurality of battery strings configured as a main subset of the plurality of battery strings and a reserve subset of the plurality of battery strings;
a battery monitoring system including a plurality of sensors, the plurality of sensors configured to measure a bus voltage of the aircraft electrical distribution bus and a battery string voltage of each battery string, the battery monitoring system further including a processor in communication with a non-transitory memory storing instructions, which instructions when executed by the processor, cause the processor to electrically connect the reserve subset of the plurality of battery strings to the aircraft electrical distribution bus by:
determining the bus voltage and the battery string voltage of each battery string of the reserve subset of the plurality of battery strings with the plurality of sensors with at least one battery string of the main subset of the plurality of battery strings electrically connected to the aircraft electrical distribution bus;
identifying a threshold voltage range of the reserve subset of the plurality of battery strings for electrically connecting the reserve subset of the plurality of battery strings to the aircraft electrical distribution bus, identifying the threshold voltage range based at least on the bus voltage; and
electrically connecting at least one battery string of the reserve subset of the plurality of battery strings to the aircraft electrical distribution bus with the bus voltage within the identified threshold voltage range, optionally, wherein:
the rotational assembly further includes a propeller and the electric motor is configured to selectively drive the propeller via the rotatable shaft.

15. The assembly of claim 14, wherein each battery string of the plurality of battery strings includes a plurality of battery modules electrically connected in series, optionally, wherein:
the plurality of battery modules of each battery string of the main subset of the plurality of battery strings have a first battery chemistry configuration;
the plurality of battery modules of each battery string of the reserve subset of the plurality of battery strings have a second battery chemistry configuration; and
the first battery chemistry configuration is different than the second battery chemistry configuration, further optionally, wherein:
the plurality of battery modules of each battery string of the main subset of the plurality of battery strings is rechargeable; and
the plurality of battery modules of each battery string of the reserve subset of the plurality of battery strings is non-rechargeable.
